# EUROPEAN PATENT SPECIFICATION

(11) **EP 4 145 326 B1**
(45) Date of publication and mention of the grant of the patent: **08.04.2026**
(21) Application number: 20898593.7
(22) Date of filing: 09.12.2020
(51) Int. Cl.: G06F 30/10

(54) **THREE-DIMENSIONAL LAYOUT METHOD, APPARATUS, AND DEVICE FOR PHYSICAL PROTECTION SYSTEM OF NUCLEAR POWER PLANT**
DREIDIMENSIONALES LAYOUTVERFAHREN, VORRICHTUNG UND VORRICHTUNG FÜR EIN PHYSISCHES SCHUTZSYSTEM EINES KERNKRAFTWERKS
PROCÉDÉ, APPAREIL ET DISPOSITIF D'IMPLANTATION TRIDIMENSIONNELLE POUR SYSTÈME DE PROTECTION PHYSIQUE DE CENTRALE NUCLÉAIRE

(30) Priority: 08.04.2020 CN 202010268684
(43) Date of publication of application: 08.03.2023
(73) Proprietor: Ling Ao Nuclear Power Co., Ltd., Shenzhen, Guangdong 518026 (CN); China Nuclear Power Engineering Co., Ltd., Shenzhen, Guangdong 518124 (CN); China General Nuclear Power Corporation, Shenzhen, Guangdong 518026 (CN); CGN Power Co., Ltd., Shenzhen, Guangdong 518026 (CN)
(72) Inventor: LIU, Jian, Shenzhen, Guangdong 518124 (CN); LIU, Guangming, Shenzhen, Guangdong 518124 (CN); ZHANG, Jiwei, Shenzhen, Guangdong 518124 (CN); LI, Shuang, Shenzhen, Guangdong 518124 (CN); LI, Xiaofeng, Shenzhen, Guangdong 518124 (CN); CHEN, Huaping, Shenzhen, Guangdong 518124 (CN); LIU, Xin, Shenzhen, Guangdong 518124 (CN); WNAG, Biyao, Shenzhen, Guangdong 518124 (CN); HE, Haibo, Shenzhen, Guangdong 518124 (CN); ZHANG, Lipeng, Shenzhen, Guangdong 518124 (CN); LV, Zhihong, Shenzhen, Guangdong 518124 (CN)
(74) Representative: Greaves Brewster LLP
(86) International application number: PCT/CN2020/134873
(87) International publication number: WO 2021/115322

(56) References cited:
- CN-A- 103 200 581
- CN-A- 105 279 331
- CN-A- 106 951 583
- CN-A- 109 376 425
- CN-A- 111 695 168
- CN-U- 206 906 857
- US-A1- 2012 039 526
- US-A1- 2017 076 015
- Y. KITA: "Position and pose detection of active camera-head in a nuclear power plant", vol. 3, 1 January 2000 (2000-01-01), Piscataway, NJ, USA, pages 1872 - 1879, XP093169825, ISBN: 978-0-7803-6348-9, Retrieved from the Internet <URL:https://ieeexplore.ieee.org/stampPDF/getPDF.jsp?tp=&arnumber=895244&ref=aHR0cHM6Ly9pZWVleHBsb3JlLmllZWUub3JnL2RvY3VtZW50Lzg5NTI0NA==> DOI: 10.1109/IROS.2000.895244

## Description

### FIELD OF THE INVENTION

The present invention generally relates to the field of nuclear power plant physical protection and, more particularly, relates to a three-dimensional layout method, apparatus and device for physical protection system of nuclear power plant.

### BACKGROUND OF THE INVENTION

A nuclear power plant is a facility which can convert nuclear energy into electricity by means of appropriate devices. Due to the particularity of nuclear energy, it is of great importance to layout monitoring and intrusion detection device in nuclear power plant to implement strict monitoring and intrusion detection.

At present, the design of physical protection system of a nuclear power plant is mainly based on two-dimensional drawing tools, such as CAD and word, and includes the steps of:
a) using two-dimensional drawing tools to draw out the layout diagram of intrusion detectors, video surveillance device, signal switching boxes, switches and servers;
b) manually counting the number of various types of intrusion detectors, video surveillance device, signal switching boxes, switches and servers, publishing equipment and material lists, switch wiring tables, signal transfer boxes wiring tables, system architectural diagram and other documents;
c) the documents produced by a) and b) above are sent to the construction site, to be used to guide the construction unit to carry out the construction on the site.

However, the prior art has the following disadvantages:
(1) Because the detection range of the intrusion detector is tridimensional, the conventional two-dimensional drawings cannot fully reflect the detection range, and the site construction can only find the existence of the intrusion detection blind region after the construction, which will lead to the site construction rework.
(2) Because the visual field of the video surveillance equipment is tridimensional, the conventional two-dimensional drawings cannot fully reflect the visual field, and the site construction can only find the existence of video surveillance blind region after the construction, which will lead to the rework of the site construction.
(3) Most of the design work is done manually, which costs a lot of manpower and it is difficult to guarantee the consistency and quality of all kinds of drawings.

US2012039526 relates to a volume-based coverage analysis for sensor placement in 3D environments.

CN206906857U relates to a command system which is monitored to three-dimensional synthesis for examining industrial field.

### SUMMARY OF THE INVENTION

The present invention relates to a three-dimensional layout method for physical protection system of nuclear power plant and a three-dimensional layout apparatus for physical protection system of nuclear power plant as defined in the claims.

One object of the present invention is to provide a three-dimensional layout method, apparatus and device for physical protection system of nuclear power plant, which can realize the three-dimensional layout of the physical protection system in nuclear power plant and avoid the appearance of blind spots.

The invention is defined by the appended claims.

According to the embodiments of the present invention, due to the adoption of a layout method for physical protection system of nuclear power plant, a possible blind region for intrusion detection and video surveillance can be detected in time during the layout phase of the device, and the location of intrusion detector or camera can be adjusted to ensure that there will not be blind region after construction. After the three-dimensional layout is completed, the required two-dimensional layout diagram can be automatically exported without additional manual processing, and the consistency of various drawings can be ensured for subsequent construction.

### BRIEF DESCRIPTION OF THE DRAWINGS

In order to illustrate the technical solutions of the embodiments of the present invention more clearly, the embodiments of the present invention will now be briefly introduced in view of the accompanying drawings used. Obviously, the accompanying drawings only show some embodiments of the present invention and should not be seen as a limitation of the protection scope of the present invention. For one ordinary skilled in the art, other drawings can also be obtained without creative effort based on these drawings.
Fig. 1 is a flow diagram of a three-dimensional layout method for physical protection system of nuclear power plant according to a first embodiment of the present invention;
Fig. 2 is a monitoring range diagram formed by a camera in a three-dimensional model of a nuclear power plant provided by the first embodiment of the present invention;
Fig. 3 is a detection range diagram formed by an intrusion detector in a three-dimensional model of a nuclear power plant provided by the first embodiment of the present invention; and
Fig. 4 is a structural diagram of a three-dimensional layout apparatus for a physical protection system of a nuclear power plant according to a second embodiment of the present invention.

### DETAILED DESCRIPTION OF THE INVENTION

In order to make the objects, technical solutions and advantages of the present invention clearer, the embodiments of the present invention will be further described in detail below with reference to the accompanying drawings. The embodiments as described are only part of the embodiments of the present invention. Based on the embodiment of the present invention, other embodiments obtained by one ordinary skilled in the art without creative work also fall within the scope of the present invention. Therefore, the following detailed description of the embodiments of the present invention provided in the attached drawings is not intended to limit the scope of the present invention, but merely represents a selected embodiment of the present invention.

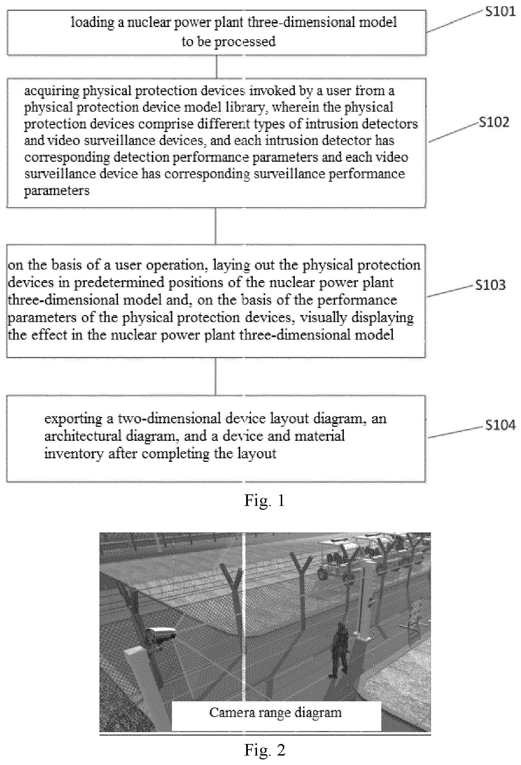

Referring to Fig. 1, a first embodiment of the invention provides a three-dimensional layout method for physical protection system of nuclear power plant, which can be performed by the three-dimensional layout device (hereinafter referred to as three-dimensional layout device) for the physical protection system of nuclear power plant and at least includes the following steps:
S101, loading a nuclear power plant three-dimensional model to be processed.

According to one embodiment of the present invention, the three-dimensional layout device may be a notebook computer, a desktop computer, or other terminal having data processing capabilities. In particular, according to one embodiment of the present invention, a three-dimensional drawing tool is installed in the three-dimensional layout device to realize three-dimensional layout.

According to one embodiment of the present invention, to achieve a three-dimensional layout, a three-dimensional model of the nuclear power plant, including the establishment of a three-dimensional coordinate system, is required first. Based on the three-dimensional model, a complete basic model of the nuclear facility is created, including plant, fences, roads, ground and various nuclear reactor facilities.

S102, acquiring physical protection devices invoked by a user from a physical protection device model library, wherein the physical protection devices include different types of intrusion detectors and video surveillance devices, and each intrusion detector has corresponding detection performance parameters, and each surveillance device has corresponding surveillance performance parameters.

According to one embodiment of the present invention, after establishing a three-dimensional model of the nuclear power plant, a physical protection device model library is required to be created. The physical protection device model library includes different types of intrusion detectors, video surveillance devices (such as cameras), signal switching boxes, switches, servers and other necessary devices for building a physical protection system.

In particular, according to one embodiment of the present invention,
the intrusion detector may include a microwave detector, an infrared detector, a tension detector and a vibration detector, containing the information of intrusion detector three-dimensional model (size information, appearance information) , detection performance data (detection stereo range);
the camera contains the information of a three-dimensional model of the camera (size information, appearance information), monitoring performance data (monitoring the three-dimensional range);
the signal switching box contains the information of: a three-dimensional model of the signal switching box (size information, appearance information), type and number of cameras can be connected;
the switch contains the information of: a three-dimensional model of the switch (size information, appearance information), the number of cameras can be connected;
the server contains the information of a three-dimensional model (size information, appearance information).

S103, on the basis of a user operation, laying out the physical protection devices in predetermined positions of the nuclear power plant three-dimensional model and, on the basis of the performance parameters of the physical protection devices, visually displaying the effect in the nuclear power plant three-dimensional model;
According to one embodiment of the present invention, the user can place each physical protection device into the three-dimensional model of the nuclear power plant by dragging, importing and so on, to complete the three-dimensional layout of the physical protection devices. At the same time, users can also establish connection relationship between the intrusion detection equipment, cameras, signal switching boxes, switches to the server via dragging.

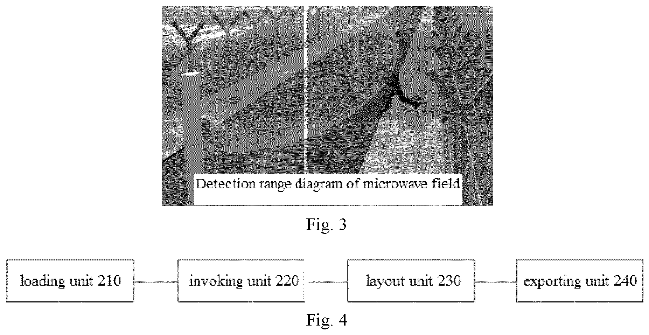

In particular, as shown in Figs. 2 and 3, according to one embodiment of the present invention, when a user places a physical protection device in a three-dimensional model of a nuclear power plant, the three-dimensional layout device can obtain performance data (tridimensional range) of the device, and according to the performance data in the display interface to display the visual detection or monitoring of its three-dimensional range, so that the user can be very intuitive access to each physical protection device of the detection or monitoring range. In this manner, the blind spots of detection or monitoring can be found in time, to adjust the location of the physical protection device or add physical protection device.

S104, exporting a two-dimensional device layout diagram, an architectural diagram, and a device and material inventory after completing the layout.

According to one embodiment of the present invention, data can be exported after layout is completed for subsequent construction needs. The user can export a two-dimensional device layout diagram, which contains the information of:
the plant building, fence, road and ground information contained in the three-dimensional model of nuclear power plant;
three-dimensional coordinate information of various types of intrusion detectors, cameras, signal switching boxes and switches.

In addition, the user can export an architecture diagram of the system, and the architecture diagram contains the information of:
a list of devices of the physical protection system, the list of devices includes all intrusion detectors, cameras, signal switching boxes, switches, servers and corresponding device types, device codes, device models, device installation location;
connection logic for intrusion detectors, cameras, signal switching boxes, switches, servers.

Due to the exported two-dimensional device layout diagram and system architectural diagram, the construction side can accurately carry out the layout and installation of physical protection device.

Due to the adoption of the three-dimensional layout method, the three-dimensional layout method for physical protection system of nuclear power plant according to one embodiment of the present invention can detect possible blind spots of intrusion detection and video surveillance, and adjust the location of physical protection device in the stage of device layout, to avoid intrusion detection or monitoring blind region after the construction.

In addition, after the three-dimensional layout is completed, the two-dimensional layout diagram required can be automatically exported without additional manual processing, and the consistency of various drawings can be ensured for subsequent construction.

To facilitate understanding of the present invention, some preferred embodiments of the present invention are described in further detail as following.

Preferably, after step S103, the three-dimensional layout method for physical protection system of nuclear power plant also includes the step of:
acquiring monitoring blind spot region of the three-dimensional model of the nuclear power plant according to the tridimensional monitoring range of all cameras, and adjusting the camera arrangement according to the information of the blind spot region to eliminate the blind spot region; and
acquiring detection blind spot region of the three-dimensional model of the nuclear power plant according to tridimensional detection range of all the intrusion detectors, and adjusting the intrusion detectors arrangement according to the information of the blind spot region to eliminate the blind spot region.

The present embodiment can avoid intrusion detection and video surveillance blind spots in important regions and ensure the comprehensiveness of detection and surveillance by automatically judging the blind spots in intrusion detection and surveillance.

Referring to Fig. 4, a second embodiment of the present invention provides a three-dimensional layout device for physical protection system of nuclear power plant, including:
a loading unit 210 for loading a nuclear power plant three-dimensional model to be processed;
an invoking unit 220 for acquiring physical protection devices invoked by a user from a physical protection device model library, wherein the physical protection devices include different intrusion detectors and video surveillance devices, and each intrusion detector has corresponding detection performance parameters and each video surveillance device has corresponding surveillance performance parameters;
a layout unit 230 for laying out the physical protection devices in predetermined positions of the nuclear power plant three-dimensional model on the basis of a user operation and, on the basis of the performance parameters of the physical protection devices, visually displaying the effect in the nuclear power plant three-dimensional model;
an exporting unit 240 for exporting a two-dimensional device layout diagram, an architectural diagram, and a device and material inventory.

Preferably, the physical protection device comprises a signal switching box, a switch and a server, wherein,
the information contained in the signal switching box includes a three-dimensional model of the signal switching box, type and number of the cameras can be connected;
the switch includes the information of a three-dimensional model of the switch, the number of cameras can be connected;
the information contained in the server includes a three-dimensional model of the server.

Preferably, the three-dimensional layout device for physical protection system of nuclear power plant also includes:
a connection unit for establishing an electrical connection between intrusion detectors, cameras and a signal switching box, switch and server.

Preferably, the three-dimensional layout device for physical protection system of nuclear power plant also includes:
a monitoring blind spot region acquisition unit for acquiring the monitoring blind spot region of the three-dimensional model of the nuclear power plant according to the tridimensional monitoring range of all cameras, and adjusting camera arrangement according to the information of the blind spot region, to eliminate the blind spot region; and
an intrusion detection blind spot region acquisition unit for acquiring the intrusion detection blind spot region of the three-dimensional model of the nuclear power plant according to the tridimensional detection range of all the intrusion detectors, and adjusting intrusion detector arrangement according to the information of the blind spot region, to eliminate the blind spot region.

The third embodiment of the present invention provides a three-dimensional layout device for physical protection system of nuclear power plant including a processor and a memory. An executable code is stored in the memory. The executable code can be executed by the processor, to realize the three-dimensional layout method for physical protection system of nuclear power plant as described above.

## Claims

1. A three-dimensional layout method for physical protection system of nuclear power plant, **characterized in that** the three-dimensional layout method comprises the steps of:
S101, loading a nuclear power plant three-dimensional model to be processed; S102,acquiring physical protection devices invoked by a user from a physical protection device model library, wherein the physical protection devices comprise different types of intrusion detectors and video surveillance devices, and each intrusion detector has corresponding detection performance parameters and each video surveillance device has corresponding surveillance performance parameters, wherein the physical protection devices further comprise a signal switching box, a switch and a server; wherein,
the intrusion detector comprises a microwave detector, an infrared detector, a tension detector and a vibration detector, and each intrusion detector has a predetermined tridimensional detection range;
the video surveillance devices comprise different types of cameras, each camera has a predetermined tridimensional monitoring range;
information contained in the signal switching box comprises a three-dimensional model of the signal switching box, type and number of the cameras can be connected;
information contained in the switch comprises a three-dimensional model of the switch, number of cameras can be connected; and
information contained in the server comprises a three-dimensional model of the server;
S103, on the basis of a user operation, laying out the physical protection devices in predetermined positions of the nuclear power plant three-dimensional model and, on the basis of the performance parameters of the physical protection devices, visually displaying the effect in the nuclear power plant three-dimensional model;
adjusting the location of the physical protection devices or adding physical protection devices to avoid blind spots of detection or monitoring; and
S104, exporting a two-dimensional device layout diagram, an architectural diagram, and a device and material inventory after completing the layout.

2. The three-dimensional layout method for physical protection system of nuclear power plant according to claim 1, **characterized in that**, the three-dimensional layout method for physical protection system of nuclear power plant further comprises the step of: establishing electrical connection relationship between the intrusion detector, the video surveillance devices and the signal switching box, the switch and the server.

3. The three-dimensional layout method for physical protection system of nuclear power plant according to claim 1, **characterized in that** the information contained in the architectural diagram comprises:
a list of devices of the physical protection system, the list of devices comprises all kinds of intrusion detectors, cameras, signal switching boxes, switches, servers and corresponding device types, device codes, device models, device installation location;
connection logic for various types of intrusion detectors, cameras, signal switching boxes, switches, and servers.

4. The three-dimensional layout method for physical protection system of nuclear power plant according to claim 1, **characterized in that** after the step of on the basis of a user operation, laying out the physical protection devices in predetermined positions of the nuclear power plant three-dimensional model and, on the basis of the performance parameters of the physical protection devices, visually displaying the effect in the nuclear power plant three-dimensional model, the three-dimensional layout method for physical protection system of nuclear power plant further comprises the steps of:
acquiring monitoring blind spot region of the three-dimensional model of the nuclear power plant according to the tridimensional monitoring range of all cameras, and adjusting the camera arrangement according to the information of the blind spot region to eliminate the blind spot region; and
acquiring detection blind spot region of the three-dimensional model of the nuclear power plant according to tridimensional detection range of all the intrusion detectors, and adjusting the intrusion detectors arrangement according to the information of the blind spot region to eliminate the blind spot region.

5. A three-dimensional layout apparatus for physical protection system of nuclear power plant, **characterized in that** the three-dimensional layout apparatus for physical protection system of nuclear power plant comprises:
a loading unit (210) for loading a nuclear power plant three-dimensional model to be processed;
an invoking unit (220) for acquiring physical protection devices invoked by a user from a physical protection device model library, wherein the physical protection devices include different intrusion detectors and video surveillance devices, and each intrusion detector has corresponding detection performance parameters and each video surveillance device has corresponding surveillance performance parameters, wherein the physical protection devices further comprise a signal switching box, a switch and a server; wherein,
the intrusion detector comprises a microwave detector, an infrared detector, a tension detector and a vibration detector, and each intrusion detector has a predetermined tridimensional detection range;
the video surveillance devices comprise different types of cameras, each camera has a predetermined tridimensional monitoring range;
information contained in the signal switching box comprises a three-dimensional model of the signal switching box, type and number of the cameras can be connected;
information contained in the switch comprises a three-dimensional model of the switch, number of cameras can be connected; and
information contained in the server comprises a three-dimensional model of the server;
a layout unit (230) for laying out the physical protection devices in predetermined positions of the nuclear power plant three-dimensional model on the basis of a user operation and, on the basis of the performance parameters of the physical protection devices, visually displaying the effect in the nuclear power plant three-dimensional model; and
an adjusting unit for adjusting the location of the physical protection devices or adding physical protection devices to avoid blind spots of detection or monitoring;
an exporting unit (240) for exporting a two-dimensional device layout diagram, an architectural diagram, and a device and material inventory.

6. The three-dimensional layout apparatus for physical protection system of nuclear power plant according to claim 5, **characterized in that** the three-dimensional layout apparatus for physical protection system of nuclear power plant further comprises a connection unit for establishing an electrical connection between the intrusion detectors, cameras and the signal switching box, switch and server.

7. The three-dimensional layout apparatus for physical protection system of nuclear power plant according to claim 5, **characterized in that** the three-dimensional layout apparatus for a physical protection system of a nuclear power plant further comprises:
a monitoring blind spot region acquisition unit for acquiring the monitoring blind spot region of the three-dimensional model of the nuclear power plant according to the tridimensional monitoring range of all cameras, and adjusting camera arrangement according to the information of the blind spot region, to eliminate the blind spot region; and
an intrusion detection blind spot region acquisition unit for acquiring the intrusion detection blind spot region of the three-dimensional model of the nuclear power plant according to the tridimensional detection range of all the intrusion detectors, and adjusting intrusion detector arrangement according to the information of the blind spot region, to eliminate the blind spot region.

## Patentansprüche

1. Dreidimensionales Layoutverfahren für ein physisches Schutzsystem eines Kernkraftwerks, **dadurch gekennzeichnet, dass** das dreidimensionale Layoutverfahren die folgenden Schritte umfasst:
S101, Laden eines zu verarbeitenden dreidimensionalen Kernkraftwerksmodells; S102, Erfassen physischer Schutzvorrichtungen, die durch einen Benutzer aus einer Modellbibliothek für physische Schutzvorrichtungen aufgerufen werden, wobei die physischen Schutzvorrichtungen verschiedene Typen von Eindringdetektoren und Videoüberwachungsvorrichtungen umfassen und jeder Eindringdetektor entsprechende Detektionsleistungsparameter aufweist und jede Videoüberwachungsvorrichtung entsprechende Überwachungsleistungsparameter aufweist, wobei die physischen Schutzvorrichtungen ferner eine Signalschaltbox, einen Schalter und einen Server umfassen; wobei
der Eindringdetektor einen Mikrowellendetektor, einen Infrarotdetektor, einen Zugspannungsdetektor und einen Schwingungsdetektor umfasst und jeder Eindringdetektor einen vorbestimmten dreidimensionalen Detektionsbereich aufweist; die Videoüberwachungsvorrichtungen verschiedene Typen von Kameras umfassen, wobei jede Kamera einen vorbestimmten dreidimensionalen Überwachungsbereich aufweist;
Informationen, die in der Signalschaltbox enthalten sind, ein dreidimensionales Modell der Signalschaltbox, Typ und Anzahl der Kameras, verbunden werden können, umfassen;
Informationen, die in dem Schalter enthalten sind, ein dreidimensionales Modell des Schalters, eine Anzahl von Kameras, verbunden werden können, umfassen; und
Informationen, die in dem Server enthalten sind, ein dreidimensionales Modell des Servers umfassen;
S103, auf der Grundlage eines Benutzervorgangs, Anordnen der physischen Schutzvorrichtungen in vorbestimmten Positionen des dreidimensionalen Kernkraftwerksmodells und, auf der Grundlage der Leistungsparameter der physischen Schutzvorrichtungen, visuelles Anzeigen der Wirkung in dem dreidimensionalen Kernkraftwerksmodell;
Anpassen des Standorts der physischen Schutzvorrichtungen oder Hinzufügen physischer Schutzvorrichtungen, um Totpunkte der Detektion oder Überwachung zu vermeiden; und
S104, Exportieren eines zweidimensionalen Vorrichtungslayoutdiagramms, eines Installationsdiagramms und eines Vorrichtungs- und Materialverzeichnisses nach Fertigstellen des Layouts.

2. Dreidimensionales Layoutverfahren für ein physisches Schutzsystem eines Kernkraftwerks nach Anspruch 1, **dadurch gekennzeichnet, dass** das dreidimensionale Layoutverfahren für ein physisches Schutzsystem eines Kernkraftwerks ferner den folgenden Schritt umfasst: Herstellen einer elektrischen Verbindungsbeziehung zwischen dem Eindringdetektor, den Videoüberwachungsvorrichtungen und der Signalschaltbox, dem Schalter und dem Server.

3. Dreidimensionales Layoutverfahren für ein physisches Schutzsystem eines Kernkraftwerks nach Anspruch 1, **dadurch gekennzeichnet, dass** die in dem Installationsdiagramm enthaltenen Informationen Folgendes umfassen:
eine Liste von Vorrichtungen des physischen Schutzsystems, wobei die Liste von Vorrichtungen alle Arten von Eindringdetektoren, Kameras, Signalschaltboxen, Schaltern, Servern und entsprechenden Vorrichtungstypen, Vorrichtungscodes, Vorrichtungsmodellen, Vorrichtungseinbaustandort umfasst;
Verbindungslogik für verschiedene Typen von Eindringdetektoren, Kameras, Signalschaltboxen, Schaltern und Servern.

4. Dreidimensionales Layoutverfahren für ein physisches Schutzsystem eines Kernkraftwerks nach Anspruch 1, **dadurch gekennzeichnet, dass** das dreidimensionale Layoutverfahren für ein physisches Schutzsystem eines Kernkraftwerks nach dem Schritt des Anordnens der physischen Schutzvorrichtungen in vorbestimmten Positionen des dreidimensionalen Kernkraftwerksmodells auf der Grundlage eines Benutzervorgangs und des visuellen Anzeigens der Wirkung in dem dreidimensionalen Kernkraftwerksmodell auf der Grundlage der Leistungsparameter der physischen Schutzvorrichtungen ferner die folgenden Schritte umfasst:
Erfassen einer Überwachungs-Totpunktregion des dreidimensionalen Modells des Kernkraftwerks gemäß dem dreidimensionalen Überwachungsbereich aller Kameras und Anpassen der Kameraaufstellung gemäß den Informationen der Totpunktregion, um die Totpunktregion zu beseitigen; und
Erfassen einer Detektions-Totpunktregion des dreidimensionalen Modells des Kernkraftwerks gemäß einem dreidimensionalen Detektionsbereich aller Eindringdetektoren und Anpassen der Eindringdetektoraufstellung gemäß den Informationen der Totpunktregion, um die Totpunktregion zu beseitigen.

5. Dreidimensionale Layouteinrichtung für ein physisches Schutzsystem eines Kernkraftwerks, **dadurch gekennzeichnet, dass** die dreidimensionale Layouteinrichtung für ein physisches Schutzsystem eines Kernkraftwerks Folgendes umfasst:
eine Ladeeinheit (210) zum Laden eines zu verarbeitenden dreidimensionalen Kernkraftwerksmodells;
eine Aufrufeinheit (220) zum Erfassen physischer Schutzvorrichtungen, die durch einen Benutzer aus einer Modellbibliothek für physische Schutzvorrichtungen aufgerufen werden, wobei die physischen Schutzvorrichtungen verschiedene Eindringdetektoren und Videoüberwachungsvorrichtungen enthalten und jeder Eindringdetektor entsprechende Detektionsleistungsparameter aufweist und jede Videoüberwachungsvorrichtung entsprechende Überwachungsleistungsparameter aufweist, wobei die physischen Schutzvorrichtungen ferner eine Signalschaltbox, einen Schalter und einen Server umfassen; wobei
der Eindringdetektor einen Mikrowellendetektor, einen Infrarotdetektor, einen Zugspannungsdetektor und einen Schwingungsdetektor umfasst und jeder Eindringdetektor einen vorbestimmten dreidimensionalen Detektionsbereich aufweist;
die Videoüberwachungsvorrichtungen verschiedene Typen von Kameras umfassen, wobei jede Kamera einen vorbestimmten dreidimensionalen Überwachungsbereich aufweist;
Informationen, die in der Signalschaltbox enthalten sind, ein dreidimensionales Modell der Signalschaltbox, Typ und Anzahl der Kameras, verbunden werden können, umfassen;
Informationen, die in dem Schalter enthalten sind, ein dreidimensionales Modell des Schalters, eine Anzahl von Kameras, verbunden werden können, umfassen; und
Informationen, die in dem Server enthalten sind, ein dreidimensionales Modell des Servers umfassen;
eine Layouteinheit (230) zum Anordnen der physischen Schutzvorrichtungen in vorbestimmten Positionen des dreidimensionalen Kernkraftwerksmodells auf der Grundlage eines Benutzervorgangs und, auf der Grundlage der Leistungsparameter der physischen Schutzvorrichtungen, visuellen Anzeigen der Wirkung in dem dreidimensionalen Kernkraftwerksmodell; und
eine Anpassungseinheit zum Anpassen des Standorts der physischen Schutzvorrichtungen oder Hinzufügen physischer Schutzvorrichtungen, um Totpunkte der Detektion oder Überwachung zu vermeiden;
eine Exportiereinheit (240) zum Exportieren eines zweidimensionalen Vorrichtungslayoutdiagramms, eines Installationsdiagramms und eines Vorrichtungs- und Materialverzeichnisses.

6. Dreidimensionale Layouteinrichtung für ein physisches Schutzsystem eines Kernkraftwerks nach Anspruch 5, **dadurch gekennzeichnet, dass** die dreidimensionale Layouteinrichtung für ein physisches Schutzsystem eines Kernkraftwerks ferner eine Verbindungseinheit zum Herstellen einer elektrischen Verbindung zwischen den Eindringdetektoren, Kameras und der Signalschaltbox, dem Schalter und dem Server umfasst.

7. Dreidimensionale Layouteinrichtung für ein physisches Schutzsystem eines Kernkraftwerks nach Anspruch 5, **dadurch gekennzeichnet, dass** die dreidimensionale Layouteinrichtung für ein physisches Schutzsystem eines Kernkraftwerks ferner Folgendes umfasst:
eine Überwachungs-Totpunktregion-Erfassungseinheit zum Erfassen der Überwachungs-Totpunktregion des dreidimensionalen Modells des Kernkraftwerks gemäß dem dreidimensionalen Überwachungsbereich aller Kameras und Anpassen der Kameraaufstellung gemäß den Informationen der Totpunktregion, um die Totpunktregion zu beseitigen; und
eine Eindringdetektions-Totpunktregion-Erfassungseinheit zum Erfassen der Eindringdetektions-Totpunktregion des dreidimensionalen Modells des Kernkraftwerks gemäß dem dreidimensionalen Detektionsbereich aller Eindringdetektoren und Anpassen der Eindringdetektoraufstellung gemäß den Informationen der Totpunktregion, um die Totpunktregion zu beseitigen.

## Revendications

1. Procédé d'implantation tridimensionnelle pour système de protection physique de centrale nucléaire, **caractérisé en ce que** le procédé d'implantation tridimensionnelle comprend les étapes de :
S101, chargement d'un modèle tridimensionnel de centrale nucléaire à traiter ; S102, acquisition de dispositifs de protection physique invoqués par un utilisateur à partir d'une bibliothèque de modèles de dispositif de protection physique, dans lequel les dispositifs de protection physique comprennent différents types de détecteurs d'intrusion et de dispositifs de vidéo surveillance, et chaque détecteur d'intrusion a des paramètres de performance de détection correspondants et chaque dispositif de vidéosurveillance a des paramètres de performance de surveillance correspondants, dans lequel les dispositifs de protection physique comprennent en outre un boîtier de commutation de signaux, un commutateur et un serveur ; dans lequel,
le détecteur d'intrusion comprend un détecteur de micro-ondes, un détecteur infrarouge, un détecteur de tension et un détecteur de vibrations, et chaque détecteur d'intrusion a une plage de détection tridimensionnelle prédéterminée ; les dispositifs de vidéosurveillance comprennent différents types de caméras, chaque caméra a une plage de surveillance tridimensionnelle prédéterminée ;
les informations contenues dans le boîtier de commutation de signaux comprennent un modèle tridimensionnel du boîtier de commutation de signaux, type et nombre de caméras pouvant être connectées ;
les informations contenues dans le commutateur comprennent un modèle tridimensionnel du commutateur, le nombre de caméras pouvant être connectées ; et
les informations contenues dans le serveur comprennent un modèle tridimensionnel du serveur ;
S103, sur la base d'une opération de l'utilisateur, l'implantation des dispositifs de protection physique à des positions prédéterminées du modèle tridimensionnel de centrale nucléaire et, sur la base des paramètres de performance des dispositifs de protection physique, l'affichage visuel de l'effet dans le modèle tridimensionnel de centrale nucléaire ;
l'ajustement de l'emplacement des dispositifs de protection physique ou l'ajout de dispositifs de protection physique pour éviter les angles morts de détection ou de surveillance ; et
S104, exportation d'un diagramme d'implantation bidimensionnelle de dispositifs, d'un diagramme architectural et d'un inventaire de dispositifs et de matériaux après avoir terminé l'implantation.

2. Procédé d'implantation tridimensionnelle pour système de protection physique de centrale nucléaire selon la revendication 1, **caractérisé en ce que** le procédé d'implantation tridimensionnelle pour système de protection physique de centrale nucléaire comprend en outre l'étape de : établissement d'une relation de connexion électrique entre le détecteur d'intrusion, les dispositifs de vidéosurveillance et le boîtier de commutation de signaux, le commutateur et le serveur.

3. Procédé d'implantation tridimensionnelle pour système de protection physique de centrale nucléaire selon la revendication 1, **caractérisé en ce que** les informations contenues dans le schéma architectural comprennent :
une liste des dispositifs du système de protection physique, la liste des dispositifs comprend toutes sortes de détecteurs d'intrusion, de caméras, de boîtiers de commutation de signaux, de commutateurs, de serveurs et les types de dispositifs correspondants, les codes de dispositifs, les modèles de dispositifs, l'emplacement d'installation des dispositifs ;
une logique de connexion pour divers types de détecteurs d'intrusion, de caméras, de boîtiers de commutation de signaux, de commutateurs et de serveurs.

4. Procédé d'implantation tridimensionnelle pour système de protection physique de centrale nucléaire selon la revendication 1, **caractérisé en ce qu'**après l'étape, sur la base d'une opération de l'utilisateur, d'implantation des dispositifs de protection physique à des positions prédéterminées du modèle tridimensionnel de centrale nucléaire et, sur la base des paramètres de performance des dispositifs de protection physique, l'affichage visuel de l'effet dans le modèle tridimensionnel de centrale nucléaire, le procédé d'implantation tridimensionnelle pour système de protection physique de centrale nucléaire comprend en outre les étapes de :
acquisition d'une région d'angle mort de surveillance du modèle tridimensionnel de la centrale nucléaire selon la plage de surveillance tridimensionnelle de toutes les caméras, et ajustement de l'agencement des caméras selon les informations de la région d'angle mort pour éliminer la région d'angle mort ; et
acquisition d'une région d'angle mort de détection du modèle tridimensionnel de la centrale nucléaire en fonction de la plage de détection tridimensionnelle de tous les détecteurs d'intrusion, et ajustement de l'agencement des détecteurs d'intrusion en fonction des informations de la région d'angle mort pour éliminer la région d'angle mort.

5. Appareil d'implantation tridimensionnelle pour système de protection physique de centrale nucléaire, **caractérisé en ce que** l'appareil d'implantation tridimensionnelle pour système de protection physique de centrale nucléaire comprend :
une unité de chargement (210) destinée à charger un modèle tridimensionnel de centrale nucléaire à traiter ;
une unité d'invocation (220) destinée à acquérir des dispositifs de protection physique invoqués par un utilisateur à partir d'une bibliothèque de modèles de dispositifs de protection physique, dans lequel les dispositifs de protection physique comprennent différents détecteurs d'intrusion et dispositifs de vidéosurveillance, et chaque détecteur d'intrusion a des paramètres de performance de détection correspondants et chaque dispositif de vidéosurveillance a des paramètres de performance de surveillance correspondants, dans lequel les dispositifs de protection physique comprennent en outre un boîtier de commutation de signaux, un commutateur et un serveur ; dans lequel,
le détecteur d'intrusion comprend un détecteur de micro-ondes, un détecteur infrarouge, un détecteur de tension et un détecteur de vibrations, et chaque détecteur d'intrusion a une plage de détection tridimensionnelle prédéterminée ;
les dispositifs de vidéosurveillance comprennent différents types de caméras, chaque caméra a une plage de surveillance tridimensionnelle prédéterminée ;
les informations contenues dans le boîtier de commutation de signaux comprennent un modèle tridimensionnel du boîtier de commutation de signaux, type et nombre de caméras pouvant être connectées ;
les informations contenues dans le commutateur comprennent un modèle tridimensionnel du commutateur, le nombre de caméras pouvant être connectées ; et
les informations contenues dans le serveur comprennent un modèle tridimensionnel du serveur ;
une unité d'implantation (230) destinée à implanter les dispositifs de protection physique à des positions prédéterminées du modèle tridimensionnel de centrale nucléaire sur la base d'une opération de l'utilisateur et, sur la base des paramètres de performance des dispositifs de protection physique, afficher visuellement l'effet dans le modèle tridimensionnel de centrale nucléaire ; et
une unité d'ajustement destinée à ajuster l'emplacement des dispositifs de protection physique ou à ajouter des dispositifs de protection physique pour éviter les angles morts de détection ou de surveillance ;
une unité d'exportation (240) destinée à exporter un diagramme d'implantation de dispositif bidimensionnel, un diagramme architectural et un inventaire de dispositifs et de matériaux.

6. Appareil d'implantation tridimensionnelle pour système de protection physique de centrale nucléaire selon la revendication 5, **caractérisé en ce que** l'appareil d'implantation tridimensionnelle pour système de protection physique de centrale nucléaire comprend en outre une unité de connexion destinée à établir une connexion électrique entre les détecteurs d'intrusion, les caméras et le boîtier de commutation de signaux, le commutateur et le serveur.

7. Appareil d'implantation tridimensionnelle pour système de protection physique de centrale nucléaire selon la revendication 5, **caractérisé en ce que** l'appareil d'implantation tridimensionnelle pour système de protection physique de centrale nucléaire comprend en outre :
une unité d'acquisition de région d'angle mort de surveillance destinée à acquérir la région d'angle mort de surveillance du modèle tridimensionnel de la centrale nucléaire selon la plage de surveillance tridimensionnelle de toutes les caméras, et à ajuster l'agencement des caméras selon les informations de la région d'angle mort, pour éliminer la région d'angle mort ; et
une unité d'acquisition de région d'angle mort de détection d'intrusion destinée à acquérir la région d'angle mort de détection d'intrusion du modèle tridimensionnel de la centrale nucléaire selon la plage de détection tridimensionnelle de tous les détecteurs d'intrusion, et à ajuster l'agencement des détecteurs d'intrusion selon les informations de la région d'angle mort, pour éliminer la région d'angle mort.
